# EUROPEAN PATENT SPECIFICATION

(11) **EP 1 432 645 B1**
(45) Date of publication and mention of the grant of the patent: **27.12.2006**
(21) Application number: 02772336.0
(22) Date of filing: 23.09.2002
(51) Int. Cl.: C01F 1/00

(54) **DIVALENT METAL OXIDE DOPED ALUMINIUM OXIDE, PRODUCED BY FLAME HYDROLYSIS AND AQUEOUS DISPERSIONS THEREOF**
MIT ZWEIWERTIGEN METALLOXIDEN DOTIERTES ALUMINIUMOXID, HERGESTELLT DURCH FLAMMENHYDROLYSE UND DARAUS HERGESTELLTE WÄSSRIGE DISPERSIONEN
OXYDE D'ALUMINIUM PRODUIT PAR HYDROLYSE A LA FLAMME ET DOPE AVEC DES OXYDES METALLIQUES BIVALENTS, ET DISPERSIONS AQUEUSES CONTENANT CET OXYDE

(30) Priority: 05.10.2001 DE 10149130
(43) Date of publication of application: 30.06.2004
(73) Proprietor: Degussa AG, 40474 Düsseldorf (DE)
(72) Inventor: LORTZ, Wolfgang, 63607 Wächtersbach (DE); HEMME, Ina, 63450 Hanau (DE); BATZ-SOHN, Christoph, 63454 Hanau (DE); MÖRTERS, Martin, 79618 Rheinfelden (DE); HABERMANN, Herbert, 63599 Biebergemünd (DE); DIENER, Uwe, 63538 Grosskrotzenburg (DE)
(86) International application number: PCT/EP2002/010638
(87) International publication number: WO 2003/031333

(56) References cited:
- EP-A- 0 995 718
- EP-A- 1 048 617
- EP-A- 1 083 151
- WO-A-00/73396
- US-A- 4 685 937

## Description

The invention relates to aluminium oxide produced by flame hydrolysis and doped with divalent metal oxides, aqueous dispersions hereof, their production and use.

Chemical-mechanical polishing, (CMP process) is a technology that is used to planarise surfaces and to produce structures into the submicron range on semiconductor wafers. For this purpose, dispersions are generally used that have one or more chemically active compounds, at least one abrasive and also a large number of additives capable of changing the properties of the dispersion depending on their desired use.

The abrasive particles which, in the CMP process, should have a high abrasion rate without scratching the surface to be polished, are particularly important. Furthermore, the dispersion should be stable against flocculation and sedimentation of the abrasive particles.

The zeta potential of the abrasive particles in the dispersion plays an important part in this. The particles in a CMP dispersion are electrically charged. This may be due to dissociation of surface groups or desorption or adsorption of ions on the particle surface. Here the electrical charge generally lies not in, but on, the surface of the particle. The zeta potential depends on the type of particle, for example silicon dioxide, aluminium oxide, magnesium oxide, cerium oxide.

An important value connected with the zeta potential is the isoelectric point (IEP). The IEP gives the pH value at which the zeta potential is zero. The IEP is at a pH of ca 9 for aluminium oxide, ca 3.8 for silicon dioxide, and ca 12.4 for magnesium oxide.

The density of the charge on the surface can be influenced by changing the concentration of the potential-determining ions in the surrounding electrolyte. In those dispersions
in which the particles carry acid or basic groups on the surface, the charge can be changed by setting the pH value. The potential can further be changed by adding salts or surfactants.

Particles of the same material will possess the same sign of the surface charge and thus repel each other. If the zeta potential is too small, however, the repelling force cannot, compensate for the Waals attraction of the particles and this may result in flocculation or sedimentation of the particles.

With various materials, for example abrasive particles and surfaces to be polished, the surface charge may have a different sign and thus be held onto the surface to be polished. This may result in uneven polishing.
Consequently, costly cleaning processes may be required after the polishing step.

As the isoelectric points of the common abrasive particles and the surfaces to be polished are often very far apart (titanium oxide ca 9.5, tungsten ca 1), it is often difficult to set a CMP dispersion in such a way that it is stable and also that no particles adhere to the surface to be polished.

The options described above for influencing the zeta potential are available in principle. However the dispersion must be considered as a whole, with all its components. Thus a shift in the pH value may increase the zeta potential, but at the same time, this may set off the decomposition of the oxidising agent. Furthermore, selectivity may be impaired, in particular with metal polishing. Finally, the additives, which are often represented in the percent range in the CMP dispersions, may themselves enter into reactions.

EP1048617 discloses an aluminium oxide doped with silicon, produced by flame hydrolysis, and the use of this material for dispersions for chemical mechanical polishing.

WO 00/73396 discloses a CMP dispersion containing abrasive particles with the spinell structure MgO·x Al₂O₃, which are obtained by calcination and the zeta potential of which may be changed by varying the magnesium oxide/aluminium oxide ratio.

The disadvantage of this process is the formation of alpha-aluminium oxide, which can cause scratching during polishing. Although stabilisation of the softer gamma-aluminium oxide phase is postulated, this is however proportionately dependent on the content of magnesium oxide. In other words, the higher the magnesium oxide content, the lower the alpha-aluminium oxide formation. As stated in WO 00/73396, even small quantities of alpha-aluminium oxide can, however, lead to scratching during polishing.

Although the formation of alpha-aluminium oxide falls as the magnesium oxide content increases, the BET specific surface area of the particle is also reduced. If a MgO·x Al₂O₃ has a BET specific surface area of 100 m²/g at x=25, at x=1 it is only 40 m²/g, which may restrict its use in CMP dispersions.

This means that a reduction in the alpha-aluminium oxide content goes hand-in-hand with a reduction in the BET specific surface area. The two values cannot be varied independently of each other.

The change in zeta potential with the magnesium content disclosed is not discussed any further. However, it can be concluded from what is said above, that a variation in the zeta potential changes the BET specific surface area and alpha-aluminium oxide content at the same time.

The object of the present invention is to provide abrasive particles in which the zeta potential and BET specific surface area can be varied indpendently of each other and which produce a largely scratch-free surface during polishing.

The invention provides an aluminium oxide doped with a divalent metal oxide, produced by flame hydrolysis and which has no spinell structures or alpha-aluminium oxide detectable in an x-ray diffractogram.

Flame hydrolysis according to the invention is understood to mean the formation of an aluminium oxide doped with a divalent metal oxide in the gas phase in a flame, which is produced by the reaction of a combustion gas and an oxygen-containing gas, preferably air. The reaction of the combustion gas with the oxygen-containing gas produces water vapour, which hydrolyses the precursor substances of aluminium oxide and the divalent metal oxide. Secondary reactions produce the aluminium oxide according to the invention. Suitable combustion gases are hydrogen, methane, ethane, propane, hydrogen being preferred in particular. During flame hydrolysis, highly-disperse, non-porous primary particles are formed first, which can grow together as the reaction progresses to form aggregates, which can further combine to form agglomerates.

The divalent metal oxide according to the invention is the doping component. A dopant is understood to mean a substance which, as a metal component, carries a divalent metal, and which is converted to the oxide during production of the powder according to the invention. The content of the doping component in the aluminium oxide according to the invention relates to the respective oxide.

In contrast to the particles disclosed in WO 0073396 the particles according to the invention have no spinell structures. This may be due to the differing production method. In the pyrogenic process on which the invention is based, no spinell phases are formed, in spite of the high temperatures. The extremely short residence time of the particles at high temperatures which, in a kinetically controlled reaction, produces particles without spinell structures, may be responsible for this. Sputtering experiments using an aluminium oxide doped with magnesium oxide as an example, have also shown that the concentration of the doping component follows a gradient, and thus the highest magnesium oxide concentration was analysed on the surface of the particle.

The BET specific surface area of the doped aluminium oxide, determined to DIN 66131, can be from 1 to 1000 m²/g. Advantageously for CMP applications, the range can be from 50 to 400 m²/g, the range 100 to 250 m²/g being particularly advantageous.

The proportion of doping component in the aluminium oxide according to the invention can be 10 ppm to 5 wt.%. The range 100 ppm to 3 wt.% is preferred, in particular the range can be 0.1 to 2 wt.%.

The doping components can be the divalent metal oxides of magnesium, calcium, zinc, manganese, copper, cobalt or iron.

An aluminium oxide with magnesium oxide as the doping component is preferred in particular.

The invention further relates to a process for the production of the doped aluminium oxide, which is characterised in that a homogeneous gas mixture of a previously vapourised aluminium halogenide and an aerosol is fed into a flame of an oxygen-containing gas and a combustion gas, as used for the production of oxides by the flame hydrolysis method, the gas mixture is allowed to react in the flame and the doped aluminium oxide formed is separated from the gas stream by a known method, the starting material of the aerosol being a solution of a divalent metal salt, and the aerosol being produced by nebulisation using an aerosol generator.

The invention further provides an aqueous dispersion containing the particles according to the invention.

The solid content of the dispersion according to the invention is primarily determined by the intended use. In order to save transport costs, the aim will be to produce a dispersion with as high a solid content as possible, whilst for certain applications, such as for example chemical-mechanical polishing, dispersions with low solid contents are used. A solid content of 0.1 to 70 wt.%, in particular in the range 1 to 30 wt.%, is preferred according to the invention. In this range, the dispersion has good stability.

The size of the aggregates of the aluminium oxide according to the invention in the dispersion can be less than 150 nm. In particular the range can be less than 100 nm.

The aqueous dispersion can have a pH value of 3 to 12. The pH value can be set by acids or bases and serves to increase the stability of the dispersion. Here, the IEP of the particles according to the invention on the one hand, and the stability of other substances in the dispersion, for example the oxidising agent, on the other, must be taken into account.

Inorganic acids, organic acids or mixtures of these can be used as acids.

In particular phosphoric acid, phosphorous acid, nitric acid, sulfuric acid, mixtures thereof and their acid reacting salts can be used as inorganic acids.

Carboxylic acids of the general formula CₙH₂ₙ₊₁CO₂H, where n=0-6 or n= 8,10,12, 14, 16, or dicarboxylic acids of the general formula HO₂C (CH₂)ₙ CO₂H, where n=0-4, or hydroxycarboxylic acids of the general formula R₁R₂C(OH)CO₂H, where R₁=H, R₂=CH₃, CH₂CO₂H, CH(OH)CO₂H, or phthalic acid or salicylic acid, or acid reacting salts of these acids or mixtures of these acids and their salts are preferred as organic acids.

The pH value can be increased by the addition of ammonia, alkali hydroxides or amines. Ammonia and potassium hydroxide are preferred in particular.

Furthermore, the dispersion according to the invention can contain 0.3 to 20 wt.% of at least one oxidising agent, which can be hydrogen peroxide, a hydrogen peroxide adduct such as for example urea adduct, an organic peracid, an inorganic peracid, an iminoperacid, a persulfate, perborate, percarbonate, oxidising metal salts and/or mixtures of these. Hydrogen peroxide and its adducts are preferred in particular.

As a result of the reduced stability of some oxidising agents in relation to other components of the dispersion according to the invention, it may be useful to add these immediately before the dispersion is used.

Furthermore, the dispersion according to the invention can contain at least one oxidation activator, the purpose of which is to increase the oxidation rate during chemical-mechanical polishing. Suitable oxidation catalysts are the metal salts of Ag, Co, Cr, Cu, Fe, Mo, Mn, Ni, Os, Pd, Ru, Sn, Ti, V and mixtures thereof. Carboxylic acids, nitriles, ureas, amides and esters are also suitable. Iron-II-nitrate is preferred in particular. The concentration of the oxidation catalyst can be varied in a range of 0.001 to 2 wt.% depending on the oxidising agent and polishing task. In particular the range can be from 0.01 to 0.05 wt.%.

The dispersion according to the invention can further contain 0.001 to 2 wt.% of at least one corrosion inhibitor. Suitable inhibitors encompass the group of nitrogen-containing heterocyclics such as benzotriazol, substituted benzimidazols, substituted pyrazines, substituted pyrazoles, glycine and mixtures thereof.

In order to stabilise the dispersion further, for example against deposition of the abrasive, flocculation and decomposition of the oxidising agent, 0.001 to 10 wt.% of at least one surfactant substance of a non-ionic, cationic, anionic or amphoteric type, can be added to it.

The invention further provides a process for the production of the dispersion with dispersing and/or milling devices, which produce an energy input of at least 200 KJ/m³. These include systems according to the rotor-stator principle, for example Ultra-Turrax machines, or mechanically agitated ball mills. Higher energy charges are possible with a planetary kneader/mixer. However, the effectiveness of this system depends on the mixture processed having a sufficiently high viscosity to incorporate the high shear energies required to disperse the particles.

High-pressure homogenisers can be used to obtain aqueous dispersions in which the aluminium oxide according to the invention can be less than 150 nm, and preferably less than 100 nm.

With these devices, two pre-dispersed suspension streams under high pressure are released through a nozzle. The two dispersion jets collide with each other exactly and the particles mill themselves. In another embodiment, the predispersion is also placed under high pressure, but the collision of the particles takes place against armoured wall areas. The operation can be repeated as often as desired to obtain smaller particles.

The invention further provides the use of the dispersion according to the invention for the chemical-mechanical polishing of metallic and non-metallic surfaces. The good stability of the dispersion according to the invention over a broad pH range makes it possible, for example, to polish aluminium, aluminium alloys, copper, copper alloys, tungsten, titanium, tantalum, silicon nitride, titanium nitride, tantalum nitride.

Furthermore, the dispersions according to the invention is suitable for the production of very fine-particle surface coatings in the paper industry or for the production of special types of glass.

### Examples

### Analysis process

The BET-surface of the powders used was determined according to DIN 66131.

The viscosity of the dispersions is determined with a Physica MCR 300 rotation rheometer and CC 27 measuring beaker. The viscosity value is determined at a shearing rate of 100 s⁻¹. This shearing rate is in a range in which the viscosity is practically independent of the shearing load.

The zeta potential is determined with a DT-1200 device from Dispersion Technology Inc, using the CVI process.

The aggregate size in the dispersion is determined by dynamic light scattering. The zetasizer 3000 Hsa (Malvern Instruments, UK) is used. The volume- and number-weighted median values of the peak analysis are given.

### Powder production

Example 1: 1.31 kg/h AlCl₃ are evaporated at ca 130 °C and transferred to the central tube of the burner. 0.538 Nm³/h (primary hydrogen), 1.35 Nm³/h air and 0.43 Nm³/h inert gas (N₂) are also fed into the central tube. The gas mixture flows out of the inner nozzle of the burner and burns in the combustion chamber and the water-cooled flame tube attached to it. 0,05 Nm³/h (shell- or secondary-) hydrogen is fed into the the shell nozzle surrounding the central nozzle to avoid baked-on deposits on the nozzles. An additional 20 Nm³/h secondary air is fed into the combustion chamber.

The second gas component flows from the axial tube into the central tube. The second gas stream consists of an aerosol charged with a magnesium salt. This magnesium salt aerosol is produced by nebulisation from a 15% aqueous magnesium nitrate solution in an aerosol generator. 71.6 g/h magnesium salt solution are atomised. This nebulised magnesium salt solution is fed through heated pipes using a carrier gas of 1.0 Nm³/h air, the salt vapour mist being converted to gas and salt crystal aerosol at temperatures of ca 180°. The temperature of the gas mixture (AlCl₃-air-hydrogen, aerosol) is measured at the burner mouth; it is 295°C.

After flame hydrolysis, the reaction gases and the aluminium oxide doped with magnesium that is formed are sucked through a cooling system by applying negative pressure and the particle gas stream is thus cooled to ca 100 to 160°C. The solid is separated from the waste gas stream in a filter or cyclone.

The aluminium oxide doped with magnesium is deposited as a white, fine-particle powder. In a further step, any hydrochloric acid residues still adhering to the particles are removed at high temperature by treatment with air containing water vapour.

Examples 2 to 7 are carried out in the same way as example 1. the parameters are given in Table 1.

### Production of the dispersion

Method A: 29.0 kg DI water and 25 g 100% acetic acid ("glacial acetic acid") are added to a 60 1 special steel charge container. 4.38 kg of the particles from example 5 are sucked in and roughly pre-dispersed using an Ystrahl dispersion and suction mixer (at 4500 rpm). During powder intake, a pH value of 4.5 +- 0.3 is maintained by the addition of acetic acid. After powder intake, dispersion is completed using an Ystrahl Z 66 rotor/stator throughput homogeniser with four processing rings, a stator slit width of 1 mm and a speed of 11 500 rpm. Before rotor/stator dispersal, a pH value of 4.5 is set by adding more acetic acid and this has not changed even after 15 minutes' dispersal at 11 500 rpm. With the 25 g acetic acid provided, 389 g were used in all. An abrasive body concentration of 12.5 wt.% is set (dispersion 8A) by adding 1.24 kg water.

Method B: Approximately half of the dispersion from method A is milled with a high pressure homogenizer, Ultimaizer System from Sugino Machine Ltd., model HJP-25050, at a pressure of 250 Mpa, a diamond nozzle diameter of 0.3 mm and two passes through the mill (dispersion 8B).

Similarly dispersions 9A and 9B are produced with the particles from example 6 and dispersions 10A and 10B with the particles from example 7.

The particles from example 6 are used with the same dispersion method to produce dispersions 11A and 11B with an abrasive body concentration of 30 wt.%. 874 g acetic acid were required to set the pH value of 4.5.

Dispersions of aluminium oxide (Alu C, Degussa AG)(dispersions 12A and 12B) are used for comparison.

The analytical data of the dispersions are shown in Table 2.

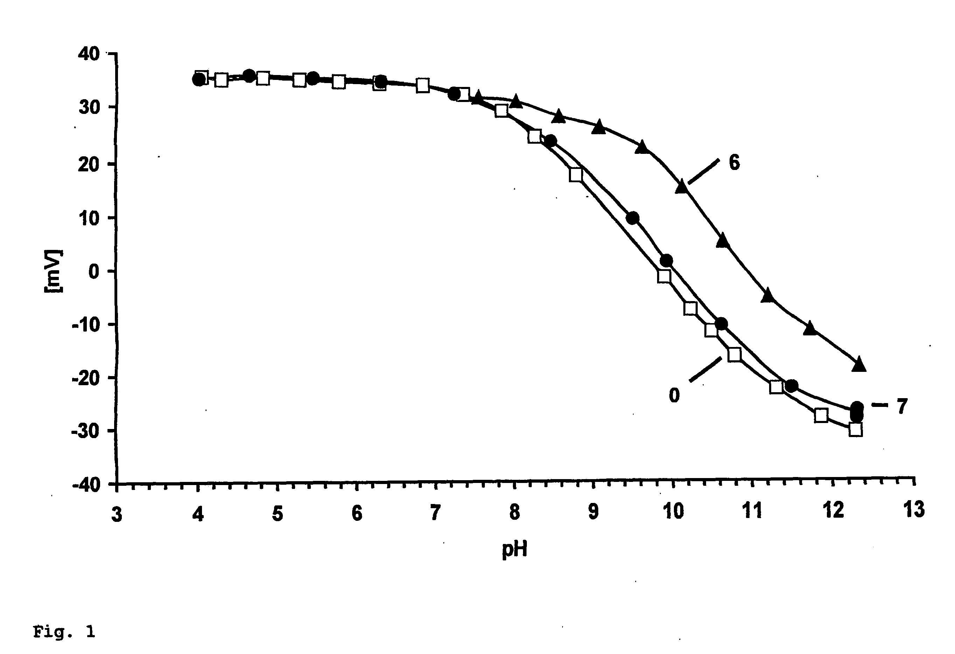

Fig. 1 shows the course of the zeta potential of the powders according to examples 6 and 7 of the invention in comparison with undoped aluminium oxide designated 0 (Alu C, Degussa AG). The value of the zeta potential depends only slightly on the proportion of the doping component in the aluminium oxide according to the invention. However the IEP can be shifted to higher pH values by increasing the content of the doping component. This means that tailor-made particles with a defined IEP can be produced and thus the application range of the dispersion can be extended without having to re-optimise the numerous other components in a CMP dispersion.

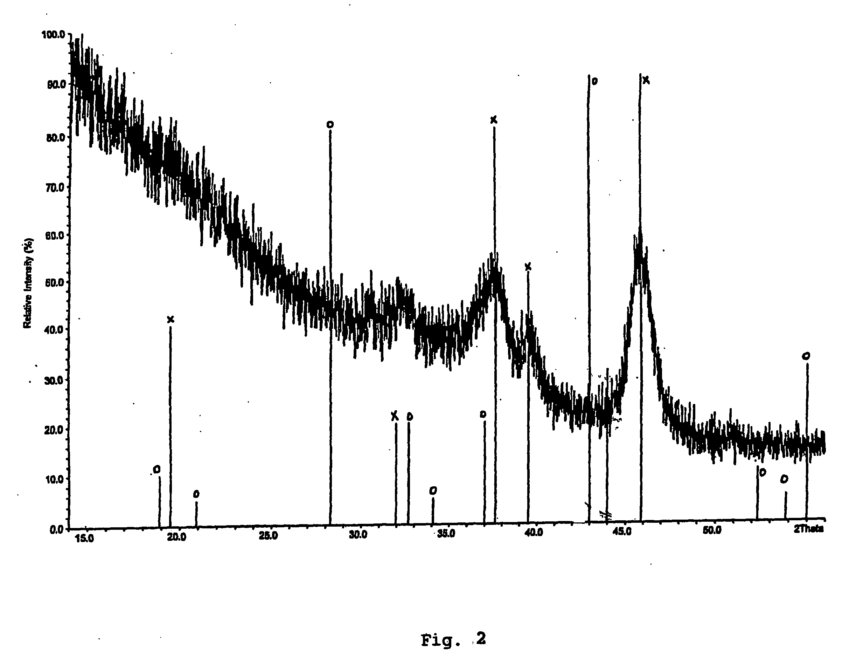

Fig. 2 shows the x-ray diffractogram of the powder according to example 6 of the invention. Reflexes of MgAl₂O₄ (spinell), designated "o" in the diffractogram, cannot be detected. The reflexes of the powder according to the invention are substantially identical to those of gamma-aluminium oxide, designated "x" in the diffractogram. The powder according to the invention shows no reflexes of alpha-aluminium oxide.

### Polishing trials

### Polishing dispersions

The dispersions of examples 8B, 9B, 10B and 12B are diluted with DI water to an abrasive particle content of 5 wt.% for polishing purposes. 1.3 wt.% glycine and 7.5 wt.% hydrogen peroxide are then added.

Polishing tool and Polishing parameters

| | | | |
|---|---|---|---|
| Polishing machine: | MECAPOL E460 (STEAG) with 46 cm platen and 6" wafer carrier | | |
| Polishing pad: | IC1400 (RODEL Corp) Pad conditioning with diamond segment after each polished wafer | | |
| Slurry quantity: | 120 ml/min for all trials | | |
| Polishing parameters: | pA | working pressure | 10 to 125 kPa |
| | | Standard | 45 and 60 kPa |
| | pR | Back pressure | 10 kPa |
| | ωₚ=ω_{c}=40 rpm (for all trials) | | |
| | Sweep = 4 cm (for all trials) | | |
| Polishing time: | 2 min | | |

After-cleaning: After polishing, the wafer is rinsed with DI water for 30 s and then cleaned on both sides and spun dry in a brush cleaning unit with spray jet and megasonic support.

### Wafer preparation

Cu: 6" Wafer with 140 nm oxide, 50 nm TaN and ca 500 or 1000 nm PVD-Cu over entire surface.

### Polishing results

Tab. 3 shows the polishing results. In comparison with polishing dispersion 16, dispersions 13 to 15 according to the invention have slightly lower copper abrasion rates irrespective of the working pressure, but have better nonuniformity.

**Table 1: Experimental conditions for the production of doped aluminium oxide and characteristics of the particles obtained**

| Example no. | AlCl₃ kg/h | Gas Temp. °C | Mg- Precursor | Precursor concentration Gew.-% | Precursor nebulised g/h | Solution nebulised g/h | Mg- content wt.% | BET-spec. Surface area m²/g |
|---|---|---|---|---|---|---|---|---|
| 1 | 1.31 | 295 | Mg(NO₃)₂ | 15 | 10.7 | 71.6 | 0.582 | 110 |
| 2 | 1.31 | 300 | Mg(NO₃)₂ | 15 | 11.3 | 75.0 | 0.610 | 53 |
| 3 | 1.31 | 287 | Mg(NO₃)₂ | 15 | 11.0 | 73.7 | 0.599 | 180 |
| 4 | 0.656 | 291 | Mg(NO₃)₂ | 15 | 11.1 | 73.8 | 1.20 | 186 |
| 5 | 1.31 | 296 | MgCl₂ | 5 | 3.0 | 59.9 | 0.253 | 105 |
| 6 | 0.656 | 294 | Mg(NO₃)₂ | 15 | 11.2 | 74.0 | 1.13 | 101 |
| 7 | 1.31 | 291 | Mg(NO₃)₂ | 5 | 2.03 | 26.1 | 0.11 | 118 |

| | | | | | | | | |
|---|---|---|---|---|---|---|---|---|
| H₂ core: 0.538 Nm³/h; H₂ shell: 0.05 Nm³/h; N₂ core: 0.43 Nm³/h; N₂ shell: 0.10 Nm³/h; Carrier gas nebuliser: 1 Nm³/h | | | | | | | | |

**Table 2: Analytical data for the dispersions**

| Example | Powder from example | Dispersion method | Content MgO- doped Al₂O₃ | Ø (Number) | Ø (Volume) | Viscosity |
|---|---|---|---|---|---|---|
| | | | [wt.%] | [nm] ⁽¹⁾ | [nm] ⁽²⁾ | [mPas] |
| 8A | 5 | A | 12.5 | 61 | 108 | 3 |
| 8B | 5 | B | 12.5 | 58 | 73 | 2 |
| 9A | 6 | A | 12.5 | 61 | 109 | 3 |
| 9B | 6 | B | 12.5 | 58 | 74 | 2 |
| 10A | 7 | A | 12.5 | 59 | 106 | 3 |
| 10B | 7 | B | 12.5 | 56 | 71 | 2 |
| 11A | 6 | A | 30 | 57 | 101 | 15 |
| 11B | 6 | B | 30 | 43 | 66 | 7 |
| 12A | Alu C | A | 12.5 | 78 | 133 | 3 |
| 12B | Alu C | B | 12.5 | 57 | 79 | 2 |

| | | | | | | |
|---|---|---|---|---|---|---|
| (1) Average particle diameter (number); (2) Average particle diameter (volume) | | | | | | |

**Table 3: Polishing results**

| Example | Dispersion from example | Abrasion nm Cu/min at 45 kPa | Abrasion nm Cu/min at 60 kPa | Non- uniformity at 45 kPa | Non-uniformity at 60 kPa |
|---|---|---|---|---|---|
| 13 | 8B | 148 | 186 | 3.4 | 4.3 |
| 14 | 9B | 155 | 191 | 4.1 | 5.5 |
| 15 | 10B | 142 | 180 | 4.3 | 6.1 |
| 16 | 12B | 164 | 205 | 5.3 | 7.7 |

## Claims

1. Aluminium oxide doped with a divalent metal oxide, produced by flame hydrolysis which has no spinell structures or alpha-aluminium oxide detectable in an x-ray diffractogram.

2. Aluminium oxide according to claim 1, **characterised in that** the BET specific surface area is 1 to 1000m²/g.

3. Aluminium oxide according to claims 1 or 2, **characterised in that** the content of the doping component is 10 ppm to 5 wt.%.

4. Aluminium oxide according to claims 1 to 3, **characterised in that** the divalent metal oxide is magnesium oxide, calcium oxide, zinc oxide, manganese oxide, copper oxide, cobalt oxide or iron oxide.

5. Process for the production of the aluminium oxide according to claims 1 to 4, **characterised in that** a homogeneous gas mixture of a previously vaporised aluminium halogenide and an aerosol is fed into a flame of an oxygen-containing gas and a combustion gas, as used for the production of oxides by the flame hydrolysis method, the gas mixture is allowed to react in the flame and the doped aluminium oxide formed is separated from the gas stream in the known way, the starting substance of the aerosol being a solution of a divalent metal salt, and the aerosol being produced by nebulisation using an aerosol generator.

6. Aqueous dispersion containing aluminium oxide according to claims 1 to 4.

7. Aqueous dispersion according to claim 6, **characterised in that** the content of doped aluminium oxide in the dispersion is 0.1 to 70 wt.% in relation to the whole dispersion.

8. Aqueous dispersion according to claims 6 or 7, **characterised in that** the average particle size of the doped aluminium oxide is smaller than 150 nm.

9. Aqueous dispersion according to claims 6 to 8, **characterised in that** its pH value is 3 to 12.

10. Aqueous dispersion according to claims 6 to 9, **characterised in that** it contains 0.3 - 20 wt.%, in relation to the whole dispersion of at least one oxidising agent.

11. Aqueous dispersion according to claims 6 to 10, **characterised in that** it contains 0.001 to 2 wt.%, in relation to the whole dispersion, of at least one oxidation activator.

12. Aqueous dispersion according to claims 6 to 11, **characterised in that** it contains 0.001 to 2 wt.%, in relation to the whole dispersion, of at least one corrosion inhibitor.

13. Aqueous dispersion according to claims 6 to 12, **characterised in that** it contains 0.001 to 10 wt.%, in relation to the whole dispersion, of at least one surfactant substance.

14. Process for the production of an aqueous dispersion according to claims 6 to 13, **characterised in that** the doped aluminium oxide is dispersed in an aqueous medium with an energy input of at least 200 KJ/m³.

15. Process for the production of an aqueous dispersion according to claim 14, **characterised in that** to mill and disperse the doped, pyrogenically produced metal oxide particles, a device is used in an aqueous medium, in which the particles to be dispersed are under pressure of up to 3500 kg/cm², are released through a nozzle and collide with each other or with wall areas of the device.

16. Use of an aqueous dispersion according to claims 6 to 13 for chemical-mechanical polishing of metallic and non-metallic surfaces.

17. Use of the aqueous dispersion according to claims 6 to 13 for the production of fine-particle surface coatings in the paper industry or for the production of special types of glass.

## Patentansprüche

1. Flammenhydrolytisch hergestelltes, mit einem zweiwertigen Metalloxid dotiertes Aluminiumoxid, welches keine im Röntgendiffraktogramm nachweisbaren Spinellstrukturen oder alpha-Aluminiumoxid aufweist.

2. Aluminiumoxid nach Anspruch 1, **dadurch gekennzeichnet, daß** die BET-Oberfläche zwischen 1 und 1000 m²/g liegt.

3. Aluminiumoxid nach den Ansprüchen 1 oder 2,
**dadurch gekennzeichnet, daß** der Anteil an Dotierungskomponente 10 ppm bis 5 Gew.-% beträgt.

4. Aluminiumoxid nach den Ansprüchen 1 bis 3, **dadurch gekennzeichnet, daß** das zweiwertige Metalloxid Magnesiumoxid, Calciumoxid, Zinkoxid, Manganoxid, Kupferoxid, Kobaltoxid oder Eisenoxid ist.

5. Verfahren zur Herstellung des Aluminiumoxids gemäß den Ansprüchen 1 bis 4, **dadurch gekennzeichnet, daß** man in eine Flamme aus einem sauerstoffhaltigen Gas und einem Brenngas, wie sie zur Herstellung von Oxiden nach der Methode der Flammenhydrolyse benutzt wird, ein homogenes Gasgemisch aus einem zuvor verdampften Aluminiumhalogenid und einem Aerosol einspeist, das Gasgemisch in der Flamme abreagieren läßt und das entstandene dotierte Aluminiumoxid in bekannter Weise vom Gasstrom abtrennt, wobei als Ausgangsstoff des Aerosols eine Lösung eines zweiwertigen Metallsalzes dient und das Aerosol durch Vernebelung unter Verwendung eines Aerosolgenerators hergestellt wird.

6. Wäßrige Dispersion, enthaltend Aluminiumoxid gemäß den Ansprüchen 1 bis 4.

7. Wäßrige Dispersion nach Anspruch 6, **dadurch gekennzeichnet, daß** der Gehalt an dotiertem Aluminiumoxid in der Dispersion 0,1 bis 70 Gew.-%, bezogen auf die gesamte Dispersion, beträgt.

8. Wäßrige Dispersion nach den Ansprüchen 6 oder 7, **dadurch gekennzeichnet, daß** die mittlere Partikelgröße des dotierten Aluminiumoxids kleiner als 150 nm ist.

9. Wäßrige Dispersion nach den Ansprüchen 6 bis 8, **dadurch gekennzeichnet, daß** deren pH-Wert 3 bis 12 beträgt.

10. Wäßrige Dispersion nach den Ansprüchen 6 bis 9, **dadurch gekennzeichnet, daß** sie 0,3-20 Gew.-%, bezogen auf die gesamte Dispersion, mindestens eines Oxidationsmittels enthält.

11. Wäßrige Dispersion nach den Ansprüchen 6 bis 10, **dadurch gekennzeichnet, daß** sie 0,001 bis 2 Gew.-%, bezogen auf die gesamte Dispersion, mindestens eines Oxidationsaktivators enthält.

12. Wäßrige Dispersion nach den Ansprüchen 6 bis 11, **dadurch gekennzeichnet, daß** sie 0,001 bis 2 Gew.-%, bezogen auf die gesamte Dispersion, mindestens eines Korrosionsinhibitors enthält.

13. Wäßrige Dispersion nach den Ansprüchen 6 bis 12 **dadurch gekennzeichnet, daß** sie 0,001 bis 10 Gew.-%, bezogen auf die gesamte Dispersion, mindestens eines oberflächenaktiven Stoffes enthält.

14. Verfahren zur Herstellung einer wäßrigen Dispersion gemäß den Ansprüchen 6 bis 13, **dadurch gekennzeichnet, daß** man das dotierte Aluminiumoxid in einem wäßrigem Medium mit einem Energieeintrag von mindestens 200 kJ/m³ dispergiert.

15. Verfahren zur Herstellung einer wäßrigen Dispersion nach Anspruch 14, **dadurch gekennzeichnet, daß** zur Vermahlung und Dispergierung der dotierten, pyrogen hergestellten Metalloxidpartikel in einem wäßrigen Medium eine Vorrichtung Verwendung findet, bei der die zu dispergierenden Partikel unter einem Druck von bis zu 3500 kg/cm² stehen, über eine Düse entspannt werden und miteinander oder mit Wandbereichen der Vorrichtung kollidieren.

16. Verwendung einer wäßrigen Dispersion gemäß den Ansprüchen 6 bis 13 zum chemisch-mechanischen Polieren von metallischen und nichtmetallischen Oberflächen.

17. Verwendung der wäßrigen Dispersion gemäß den Ansprüchen 6 bis 13 zur Erzeugung feinteiliger Oberflächenbeschichtungen in der Papierindustrie oder zur Erzeugung spezieller Gläser.

## Revendications

1. Oxyde d'aluminium dopé à l'aide d'un oxyde de métal divalent, produit par hydrolyse à la flamme qui n'a aucune structure de spinelle ni aucun oxyde d'aluminium alpha détectable dans un spectre de diffraction aux rayons X.

2. Oxyde d'aluminium selon la revendication 1,
**caractérisé en ce que** la superficie spécifique BET est de 1 à 1 000 m²/g.

3. Oxyde d'aluminium selon les revendications 1 ou 2, **caractérisé en ce que** la teneur en composant de dopage est de 10 ppm à 5 % en poids.

4. Oxyde d'aluminium selon les revendications 1 à 3, **caractérisé en ce que** l'oxyde métallique divalent est l'oxyde de magnésium, l'oxyde de calcium, l'oxyde de zinc, l'oxyde de manganèse, l'oxyde de cuivre, l'oxyde de cobalt ou l'oxyde de fer.

5. Procédé en vue de la production de l'oxyde d'aluminium selon les revendications 1 à 4, **caractérisé en ce qu'**un mélange gazeux homogène d'un halogénure d'aluminium vaporisé antérieurement et un aérosol sont alimentés dans une flamme d'un gaz contenant de l'oxygène et d'un gaz de combustion, tels qu'ils sont utilisés en vue de la production d'oxydes par le procédé de l'hydrolyse à la flamme, **en ce que** l'on permet au mélange gazeux de réagir dans la flamme et **en ce que** l'oxyde d'aluminium dopé formé est séparé du courant gazeux de la manière connue, la substance de départ de l'aérosol étant une solution d'un sel de métal divalent et l'aérosol étant produit par nébulisation en utilisant un générateur d'aérosols.

6. Dispersion aqueuse contenant l'oxyde d'aluminium selon les revendications 1 à 4.

7. Dispersion aqueuse selon la revendication 6,
**caractérisée en ce que** la teneur en oxyde d'aluminium dopé dans la dispersion est de 0,1 à 70 % en poids par rapport à la dispersion tout entière.

8. Dispersion aqueuse selon les revendications 6 ou 7, **caractérisée en ce que** la taille moyenne de particule de l'oxyde d'aluminium dopé est inférieure à 150 nm.

9. Dispersion aqueuse selon les revendications 6 à 8, **caractérisée en ce que** sa valeur de pH est de 3 à 12.

10. Dispersion aqueuse selon les revendications 6 à 9, **caractérisée en ce qu'**elle contient 0,3 - 20 % en poids, par rapport à la dispersion tout entière, d'au moins un agent oxydant.

11. Dispersion aqueuse selon les revendications 6 à 10, **caractérisée en ce qu'**elle contient 0,001 à 2 % en poids, par rapport à la dispersion tout entière, d'au moins un agent activateur de l'oxydation.

12. Dispersion aqueuse selon les revendications 6 à 11, **caractérisée en ce qu'**elle contient 0,001 à 2 % en poids, par rapport à la dispersion tout entière, d'au moins un agent inhibiteur de la corrosion.

13. Dispersion aqueuse selon les revendications 6 à 12, **caractérisée en ce qu'**elle contient 0,001 à 10 % en poids, par rapport à la dispersion tout entière, d'au moins un agent tensioactif.

14. Procédé en vue de la production d'une dispersion aqueuse selon les revendications 6 à 13, **caractérisé en ce que** l'oxyde d'aluminium dopé est dispersé dans un milieu aqueux avec un apport d'énergie d'au moins 200 KJ/m³.

15. Procédé en vue de la production d'une dispersion aqueuse selon la revendication 14, **caractérisé en ce qu'**en vue de la mouture et de la dispersion des particules d'oxyde de métal dopées, produites par voie pyrogène, on utilise un dispositif dans un milieu aqueux dans lequel les particules à disperser sont mises sous une pression allant jusqu'à 3 500 kg/cm², sont libérées à travers une buse et entrent en collision les unes avec les autres ou avec les surfaces des parois du dispositif.

16. Utilisation d'une dispersion aqueuse selon les revendication 6 à 13, en vue du polissage mécanico-chimique de surfaces métalliques et non métalliques.

17. Utilisation de la dispersion aqueuse selon les revendications 6 à 13 en vue de la production de revêtements superficiels à particules fines dans l'industrie du papier ou en vue de la production de types de verre spéciaux.
